# EUROPÄISCHE PATENTANMELDUNG

(11) **EP 2 484 797 A1**
(43) Veröffentlichungstag der Anmeldung: **08.08.2012**
(21) Anmeldenummer: 11153162.0
(22) Anmeldetag: 03.02.2011
(51) Int. Cl.: C23C 14/20

(54) **Lumineszierender Gegenstand**

(71) Anmelder: RC Tritec AG, 9053 Teufen (CH)
(72) Erfinder: Zeller-Mannhart, Albert, 9053, Teufen (CH); Walfort, Bernhard, 9245, Oberbüren (CH)
(74) Vertreter: Hepp Wenger Ryffel AG

(57) **Zusammenfassung**

Die Erfindung betrifft einen Gegenstand (1), enthaltend ein lumineszierendes, insbesondere phosphoreszierendes Substrat (2) mit mindestens einer äusseren Oberfläche (3) sowie mindestens eine wenigstens teilweise transparente Deckschicht (4), welche direkt oder indirekt auf der äusseren Oberfläche (3) des Substrates (2) angeordnet ist. Die transparente Deckschicht (4) enthält mindestens ein Metall und/oder mindestens eine Metallverbindung enthält oder daraus besteht. Die Deckschicht (4) weist bei einem Einfallswinkel von 60° einen Reflektometerwert auf, der mindestens 5, bevorzugt mindestens 10, besonders bevorzugt mindestens 15 beträgt. Weiterhin betrifft die Erfindung ein Verfahren zur Herstellung eines solchen Gegenstandes (1).

## Beschreibung

Die vorliegende Erfindung betrifft einen lumineszierenden Gegenstand sowie ein Verfahren zur Herstellung eines solchen Gegenstandes gemäss den Oberbegriffen der unabhängigen Patentansprüche.

Ein gattungsgemässer Gegenstand ist beispielsweise aus der EP 0 635 582 bekannt. Dieser Gegenstand enthält ein Substrat mit einer Harzschicht, einer Metallschicht, einer Schicht mit einem fluoreszierenden Farbstoff sowie einer äusseren Deckschicht. Aufgrund der fluoreszierenden Schicht kann beispielsweise eine bessere Sichtbarkeit des Gegenstandes bei schlechtem Wetter in der Dämmerung erzielt werden. Damit das von aussen eintreffende Licht die fluoreszierende Schicht erreichen und das von ihr emittierte Licht sie wieder verlassen kann, muss die äussere Schicht offensichtlich zumindest teilweise transparent sein.

Dieser bekannte lumineszierende Gegenstand weist jedoch eine Reihe von Nachteilen auf. Zwar ist der Gegenstand bei Dunkelheit aufgrund der fluoreszierenden Schicht leicht und sicher zu erkennen, da er sich dann von seiner nicht fluoreszierenden Umgebung abhebt. Bei stärkerem Lichteinfall hingegen tritt dieser Effekt in den Hintergrund, da die äussere Deckschicht das einfallende Licht in alle Richtungen streut; der Gegenstand hebt sich dann kaum noch von seiner Umgebung ab. Zudem ist die transparente Deckschicht bei dem bekannten Gegenstand nicht sehr resistent gegenüber äusseren Einflüssen, insbesondere gegenüber physikalischen und/oder chemischen Einflüssen. Beispielsweise können leicht Kratzer entstehen, oder die Deckschicht kann durch Witterungseinflüsse beeinträchtigt werden. Zwar ist es möglich, die Deckschicht entsprechend dicker zu gestalten. Dies kann den Gegenstand jedoch einerseits unhandlicher machen oder die Transparenz derart herabsetzen, dass das von der fluoreszierenden Schicht emittierte Licht kaum noch hindurch treten kann. Ausserdem besteht die Gefahr, dass die Deckschicht aufgrund ihrer Dicke leicht abgeschält werden kann.

Es ist daher eine Aufgabe der vorliegenden Erfindung, die Nachteile des Standes der Technik zu überwinden. Insbesondere soll ein Gegenstand mit einem lumineszierenden Substrat und einer Deckschicht geschaffen werden, der nicht nur bei geringem Lichteinfall leicht und sicher zu erkennen ist, sondern sich auch bei stärkerem Lichteinfall optisch von seiner Umgebung abhebt. Zudem soll die Deckschicht resistent gegenüber äusseren Einflüssen sein, ohne jedoch die Lumineszenz bei geringerem Lichteinfall verhindern.

Diese Aufgabe wird gelöst durch einen Gegenstand, der ein lumineszierendes, insbesondere phosphoreszierendes Substrat mit mindestens einer äusseren Oberfläche und mindestens einer transparenten Deckschicht enthält, welche direkt oder indirekt auf zumindest einem Teil der äusseren Oberfläche des Substrates angeordnet ist.

Bei dem Gegenstand im Sinne der Erfindung handelt es sich um ein makroskopisches Objekt mit Abmessungen, die grösser sind als 0,1 mm, bevorzugt grösser als 0,5 mm, weiter bevorzugt grösser als 1 mm, besonders bevorzugt grösser als 10 mm. Insbesondere umfasst der Begriff "Gegenstand" also keine Farbpigmente.

Der Gegenstand kann in einer Vielzahl von Ausgestaltungen vorliegen, beispielsweise als Türgriff, Armatur (etwa als Küchenarmatur oder Badezimmerarmatur), als Bedienungselement (beispielsweise als Schalter, Schaltknopf, Hebel, Drehrad oder Steuerknüppel), als Anzeigeelement (beispielsweise als Tachozeiger), als Tastatur, als Zierleiste (insbesondere in oder an einem Fahrzeug), als Fahrzeugzubehör, als Fluchtwegmarkierung, als Geländer, als Schild, als Etikett, als Uhrzeiger, als Uhrzifferblatt, als Uhrgehäuse, als Uhrarmband oder als Schmuckgegenstand.

Im Sinne der vorliegenden Erfindung wird die Deckschicht als "transparent" bezeichnet, wenn sie für zumindest eine Frequenz, bevorzugt für alle Frequenzen des von dem lumineszierenden Substrat emittierten oder emittierbaren Lichtes sowie für mindestens eine Frequenz, bevorzugt für alle Frequenzen, die zur Anregung der Lumineszenz erforderlich ist, durchlässig ist. Besonders bevorzugt ist die Deckschicht im Bereich eines Intensitätsmaximums der emittierten oder emittierbaren Strahlung durchlässig. Je nach Anforderungen kann die transparente Deckschicht nur einen Teil oder auch die gesamte äussere Oberfläche des Substrates bedecken. Weiterhin ist es auch denkbar und liegt im Rahmen der Erfindung, dass eine Deckschicht die gesamte äussere Oberfläche des Substrates bedeckt aber nur im Bereich eines Teiles dieser äusseren Oberfläche transparent ist. Die transparenten und die nicht transparenten Bereiche der Deckschicht können beispielsweise durch entsprechende Wahl einer räumlich variablen Dicke der Deckschicht erreicht werden.

Erfindungsgemäss enthält die transparente Deckschicht mindestens ein Metall und/oder mindestens eine Metallverbindung oder besteht daraus. Das Metall kann insbesondere als elementares Reinmetall oder als Metalllegierung vorliegen. Die Deckschicht weist bei einem Einfallswinkel von 60° einen Reflektometerwert auf, der mindestens 5, bevorzugt mindestens 10, besonders bevorzugt mindestens 15, noch weiter bevorzugt mindestens 20, weiterhin bevorzugt mindestens 30, noch weiter bevorzugt mindestens 40, besonders bevorzugt mindestens 50, weiterhin bevorzugt mindestens 100, noch weiter bevorzugt mindestens 200 und ganz besonders bevorzugt mindestens 500 beträgt.

Die genannten Reflektometerwerte können beispielsweise gemäss DIN 67530 (Januar 1982) bestimmt werden. Zur Kalibrierung des Reflektometers kann das Verfahren gemäss Abschnitt 4.2 der genannten Norm durchgeführt werden. Als Reflektometer kann beispielsweise das Gerät ZGM 1110 der Firma Zehntner GmbH, Testing Instruments, Gewerbestrasse 4, CH-4450 Sissach, Schweiz verwendet werden.

Aufgrund dieser Eigenschaften kann ein grosser Anteil des Lichtes von dem Gegenstand reflektiert werden. Der Gegenstand kann sich also bei stärkerem Lichteinfall von einer nicht reflektierenden Umgebung optisch abheben. Dennoch erlaubt es die Transparenz der Deckschicht, dass auch bei schwächerem oder gar keinem äusseren Lichteinfall Licht vom lumineszierenden Substrat durch die Deckschicht hindurch treten kann, so dass der Gegenstand auch bei diesen Lichtverhältnissen leicht und sicher zu erkennen ist.

Überdies verleiht das Metall und/oder die Metallverbindung der Deckschicht eine wesentlich erhöhte Resistenz gegenüber äusseren Einflüssen, wie beispielsweise Umwelteinflüssen.

Zudem kann ein in der transparenten Deckschicht enthaltene Metall auch zusätzlich einen ästhetischen Zweck erfüllen. Bei genügend hohem Metallanteil kann der Eindruck einer metallischen Oberfläche entstehen. Dies kann etwa bei Zierleisten an Fahrzeugkarosserien erwünscht sein. Nur bei entsprechenden Lichtverhältnissen kommt die Lumineszenz zum Vorschein, beispielsweise wenn das Fahrzeug in einen Tunnel hinein fährt.

Für die Erfindung ist es nicht erforderlich, dass das gesamte Substrat lumineszierend ist. Es genügt, wenn das Substrat nur im Bereich der äusseren Oberfläche oder nur ein Teil dieser äusseren Oberfläche lumineszierend ist. Das Substrat selbst kann ebenfalls mehrschichtig aufgebaut sein. Beispielsweise kann es einen Grundkörper aufweisen, dessen Oberfläche der mit einer lumineszierenden, insbesondere phosphoreszierenden Beschichtung versehen ist. In dieser Falle bilden der Grundkörper und die Beschichtung zusammen das Substrat, und die äussere Oberfläche der Beschichtung bildet die äussere Oberfläche des Substrates.

Die transparente Deckschicht kann mindestens ein elementares Metall wie beispielsweise Chrom, Aluminium, Kupfer, Nickel oder Legierungen davon enthalten oder daraus bestehen. Es kann jedoch auch Metallverbindungen enthalten oder daraus bestehen, die die erforderliche Reflexion liefern, beispielsweise Siliziumnitrid. Bevorzugt enthält die transparente Deckschicht im Wesentlichen keine Metalloxide. Insbesondere kann sie höchstens 1 %, weiter bevorzugt höchstens 0,5 %, besonders bevorzugt höchstens 0,2 %, besonders bevorzugt gar keine Metalloxide enthalten. Neben dem Metal und/oder der Metallverbindung kann die Deckschicht auch noch weitere Inhaltsstoffe enthalten, solange die Reflexion nicht beeinträchtigt wird.

Für die Erfindung ist es von Bedeutung, dass die Deckschicht transparent ist. Zu diesem Zweck hat die transparente Deckschicht bevorzugt eine Dicke im Bereich von 1 nm bis 200 µm, bevorzugt im Bereich von 5 nm bis 150 µm, besonders bevorzugt im Bereich von 10 nm bis 100 µm. Aufgrund des erfindungsgemässen Anteils des Metalls und/oder der Metallverbindung in der Deckschicht genügen derartige Dicken jedoch, um die Deckschicht ausreichend resistent zu gestalten und auch für genügend Reflexion zu sorgen.

Derart dünne transparente Deckschichten können mit an sich bekannten Verfahren auf die äussere Oberfläche des Substrates aufgetragen werden. Bevorzugt wird die transparente Deckschicht mittels physikalischer Gasphasenabscheidung ("physical vapour deposition", PVD) und/oder chemischer Gasphasenabscheidung ("chemical vapour deposition", CVD) aufgetragen. Diese Verfahren erlauben die Herstellung dünner Schichten, wie sie für die Erfindung erforderlich ist. Darüber hinaus können durch beide Verfahren Beschichtungen mit äusserst gleichmässiger Dicke erreicht werden.

Alternativ dazu kann die transparente Deckschicht aber beispielsweise auch mittels eines elektrochemischen Verfahrens und/oder mittels eines Tauchverfahrens aufgetragen sein. Auch mit diesen Verfahren können ausreichend dünne Schichten erzeugt werden.

Bevorzugt weist die transparente Deckschicht eine derartige Dicke auf, dass sie einen Intensitätsabfall von höchstens 99 %, bevorzugt höchstens 98 %, besonders bevorzugt höchstens 95 % bewirkt.

Der Intensitätsabfall ist dabei wie folgt definiert: Es werden einerseits ein Gegenstand mit einem Substrat und einer erfindungsgemässen transparenten Deckschicht und andererseits ein Vergleichsgegenstand bereitgestellt, der das gleiche Substrat enthält, jedoch keine erfindungsgemässe transparente Deckschicht. Sowohl der beschichtete Gegenstand als auch der Vergleichsgegenstand werden mit einer Normlichtquelle beleuchtet. Die Normlichtquelle und die Belichtung werden gemäss der Leuchtdichtemessung nach ISO 17514:2004 festgelegt. Als Normlichtquelle dient eine D65-Leuchtstoffröhre, z. B. Osram Vitalux. Das Licht der Normlichtquelle wird dabei für 20 Minuten und mit einer Beleuchtungsstärke von 400 Lux senkrecht auf die Oberfläche des Gegenstandes gerichtet. Anschliessend wird die Normlichtquelle ausgeschaltet, und es wird sowohl beim beschichteten Gegenstand als auch beim Vergleichsgegenstand die Intensität des Lichtes gemessen, welches aufgrund der Lumineszenz des Substrates senkrecht zur Oberfläche des Gegenstandes emittiert wird. Der prozentuale Anteil, um den das vom beschichteten Gegenstand emittierte Licht geringer ist als das vom Vergleichsgegenstand emittierte Licht, ist definitionsgemäss der Intensitätsabfall. In bevorzugten Ausführungsformen ist die transparente Deckschicht direkt mit der äusseren Oberfläche des Substrates verbunden. Hierdurch lassen sich besonders dünne, einfach aufgebaute und widerstandsfähige Beschichtungen erzielen. Alternativ ist es jedoch auch möglich und liegt im Rahmen der Erfindung, dass zwischen der äusseren Oberfläche des Substrates und der transparenten Deckschicht mindestens eine weitere Schicht vorhanden ist, wie beispielsweise eine haftvermittelnde Schicht. Diese sollte ebenfalls zumindest für einen Teil des von dem lumineszierenden Substrat emittierten oder emittierbaren Lichtes durchlässig sein.

Bevorzugt ist auf der erfindungsgemässen transparenten Deckschicht noch mindestens eine weitere transparente Schutzschicht angeordnet. Diese Schutzschicht muss nicht zwingend ein Metall oder eine Metallverbindung enthalten.

Vorteilhafterweise enthält das Substrat lumineszierende, insbesondere phosphoreszierende Pigmente, die in einem Trägermaterial gebunden sind. Derartige lumineszierende Pigmente, insbesondere phosphoreszierende Pigmente, sind dem Fachmann an sich bekannt. Bei den lumineszierenden Pigmenten kann es sich beispielsweise um mit Seltenerdmetallen dotierte Erdalkalialuminate handeln, wie beispielsweise SrAl₂O₄:Eu, Dy oder Sr₄Al₂O₂₅ :Eu, Dy, und/oder um Zinksulfide, wie beispielsweise ZnS:Cu oder ZnS:Cu,Al oder beliebige Mischungen davon.

Die lumineszierenden Pigmente sind vorzugsweise derart ausgewählt, dass sie mit Licht im Wellenlängenbereich von 250 nm bis 480 nm angeregt werden können und Licht im Wellenlängenbereich von 420 nm bis 700 nm emittieren können.

Das Trägermaterial kann einen Kunststoff, ein Harz, eine Keramik, ein Glas, einen Lack oder eine Mischung davon enthalten oder daraus bestehen. Derartige Trägermaterialien sind besonders widerstandsfähig.

Ein weiterer Aspekt der Erfindung betrifft ein Verfahren zur Herstellung eines wie oben beschriebenen Gegenstandes. Dieses Verfahren enthält die folgenden Schritte:
a) Herstellung oder Bereitstellung eines lumineszierenden, insbesondere phosphoreszierenden Substrates mit mindestens einer äusseren Oberfläche,
b) Aufbringung einer transparenten Deckschicht auf wenigstens einen Teil der äusseren Oberfläche des Substrates.

Erfindungsgemäss enthält die transparente Deckschicht mindestens ein Metall und/oder mindestens eine Metallverbindung oder besteht daraus. Das Metall kann beispielsweise aus der oben beschriebenen Gruppe ausgewählt sein und/oder eine Dicke in den oben beschriebenen Bereichen aufweisen. Die Deckschicht wird dabei in einer derartigen Dicke aufgebracht, dass sie bei einem Einfallswinkel von 60° einen Reflektometerwert aufweist, der mindestens 5, bevorzugt mindestens 10, besonders bevorzugt mindestens 15, noch weiter bevorzugt mindestens 20, weiterhin bevorzugt mindestens 30, noch weiter bevorzugt mindestens 40, besonders bevorzugt mindestens 50, weiterhin bevorzugt mindestens 100, noch weiter bevorzugt mindestens 200 und ganz besonders bevorzugt mindestens 500 beträgt.

Bevorzugt wird in Schritt b) die transparente Deckschicht mittels physikalischer Gasphasenabscheidung und/oder chemischer Gasphasenabscheidung aufgetragen. Diese Verfahren sind dem Fachmann an sich bekannt. Alternativ dazu kann die transparente Deckschicht aber beispielsweise auch mittels eines elektrochemischen Verfahrens und/oder mittels eines Tauchverfahrens aufgetragen werden. Auch mit diesen Verfahren können ausreichend dünne Schichten erzeugt werden.

Im Folgenden wird die Erfindung anhand eines Ausführungsbeispiels und einer Figur beschrieben.

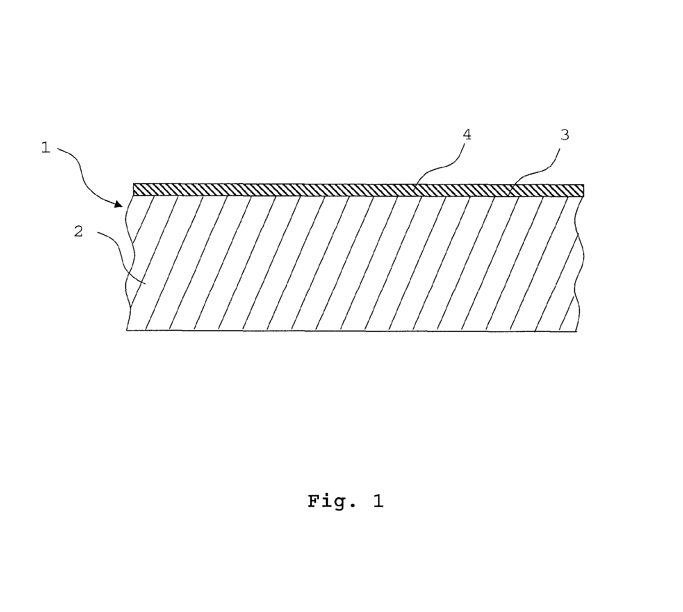

Die Figur 1 zeigt in einer seitlichen, nicht massstabsgerechten Schnittansicht einen Teil eines erfindungsgemässen Gegenstandes 1. Bei dem Gegenstand 1 kann es sich beispielsweise um einen Türgriff, eine Zierleiste oder eine Fluchtwegmarkierung handeln. Der Gegenstand 1 enthält ein phosphoreszierendes Substrat 2 mit einer äusseren Oberfläche 3. Die äussere Oberfläche 3 ist mit einer transparenten Deckschicht 4 überzogen. In dem hier dargestellten Ausführungsbeispiel bedeckt die transparente Deckschicht 4 die komplette äussere Oberfläche 3 des Substrates 2. Es ist jedoch denkbar und liegt im Rahmen der Erfindung, dass nur Teile der äusseren Oberfläche 3 von der Deckschicht 4 bedeckt sind.

Das Substrat 2 enthält phosphoreszierende Pigmente, die in einem Trägermaterial gebunden sind. Bei den Pigmenten kann es sich beispielsweise um SrAl₂O₄:Eu, Dy handeln. Sie können Partikelgrössen im Bereich von 1 µm bis 100 µm aufweisen. Das Trägermaterial kann beispielsweise Kunststoff sein. Die Herstellung eines solchen Pigmente enthaltenden Trägermaterials ist dem Fachmann hinlänglich bekannt.

Die transparente Deckschicht 4 besteht aus Chrom und hat eine Dicke von etwa 500 nm. Hierdurch wird erreicht, dass die Deckschicht 4 einen wie oben definierten Intensitätsabfall von 90 % aufweist. Die Deckschicht 4 kann durch physikalische Gasphasenabscheidung auf die äussere Oberfläche 3 des Substrates aufgetragen werden.

## Patentansprüche

1. Gegenstand (1), enthaltend
- ein lumineszierendes, insbesondere phosphoreszierendes Substrat (2) mit mindestens einer äusseren Oberfläche (3) und
- mindestens eine transparente Deckschicht (4), welche direkt oder indirekt auf wenigstens einem Teil der äusseren Oberfläche (3) des Substrates (2) angeordnet ist,
**dadurch gekennzeichnet, dass**
die transparente Deckschicht (4) mindestens ein Metall und/oder mindestens eine Metallverbindung enthält oder daraus besteht und bei einem Einfallswinkel von 60° einen Reflektometerwert aufweist, der mindestens 5, bevorzugt mindestens 10, weiter bevorzugt mindestens 15 beträgt.

2. Gegenstand (1) gemäss Anspruch 1,
**dadurch gekennzeichnet, dass**
die transparente Deckschicht (4) Chrom, Aluminium, Kupfer und/oder Nickel enthält oder daraus besteht.

3. Gegenstand (1) gemäss einem der vorangehenden Ansprüche,
**dadurch gekennzeichnet, dass**
die transparente Deckschicht (4) eine Dicke im Bereich von 1 nm bis 200 µm, bevorzugt im Bereich von 5 nm bis 150 µm, besonders bevorzugt im Bereich von 10 nm bis 100 µm aufweist.

4. Gegenstand (1) gemäss einem der vorangehenden Ansprüche,
**dadurch gekennzeichnet, dass**
die transparente Deckschicht (4) mittels physikalischer Gasphasenabscheidung und/oder chemischer Gasphasenabscheidung und/oder durch ein elektrochemisches Verfahren und/oder durch ein Tauchverfahren aufgetragen wurde.

5. Gegenstand (1) gemäss einem der vorangehenden Ansprüche,
**dadurch gekennzeichnet, dass**
die transparente Deckschicht (4) eine derartige Dicke aufweist, dass sie einen Intensitätsabfall von höchstens 99 %, bevorzugt höchstens 98 %, besonders bevorzugt höchstens 95 % bewirkt

6. Gegenstand (1) gemäss einem der vorangehenden Ansprüche,
**dadurch gekennzeichnet, dass**
die transparente Deckschicht (4) direkt mit der äusseren Oberfläche (3) des Substrates (2) verbunden ist.

7. Gegenstand (1) gemäss einem der Ansprüche 1 bis 5,
**dadurch gekennzeichnet, dass**
zwischen der äusseren Oberfläche (3) des Substrates (2) und der transparenten Deckschicht (4) mindestens eine weitere Schicht vorhanden ist, wie beispielsweise eine haftvermittelnde Schicht.

8. Gegenstand (1) gemäss einem der vorangehenden Ansprüche,
**dadurch gekennzeichnet, dass**
auf der transparenten, Metall enthaltenden oder aus Metall bestehenden Deckschicht (4) mindestens eine transparente Schutzschicht angeordnet ist.

9. Gegenstand (1) gemäss einem der vorangehenden Ansprüche,
**dadurch gekennzeichnet, dass**
das Substrat (2) lumineszierende, insbesondere phosphoreszierende Pigmente enthält, die in einem Trägermaterial gebunden sind.

10. Gegenstand (1) gemäss Anspruch 9,
**dadurch gekennzeichnet, dass**
die lumineszierenden, insbesondere phosphoreszierenden Pigmente mit Seltenerdmetallen dotierte Erdalkalialuminate, wie beispielsweise SrAl₂O₄:Eu, Dy oder Sr₄Al₁₄O₂₅:Eu, Dy, und/oder Zinksulfide, wie beispielsweise ZnS:Cu oder ZnS:Cu,Al oder beliebige Mischungen davon enthalten oder daraus bestehen.

11. Gegenstand (1) gemäss einem der Ansprüche 9 und 10,
**dadurch gekennzeichnet, dass**
das Trägermaterial einen Kunststoff, ein Harz, eine Keramik, ein Glas, einen Lack oder eine Mischung davon enthält oder daraus besteht.

12. Gegenstand (1) gemäss einem der vorangehenden Ansprüche,
**dadurch gekennzeichnet, dass**
er als Türgriff, Armatur (beispielsweise als Küchenarmatur oder Badezimmerarmatur), Bedienungselement (etwa als Schalter, Schaltknopf, Hebel, Drehrad oder Steuerknüppel), als Anzeigeelement (beispielsweise als Tachozeiger), Tastatur, Zierleiste (insbesondere in oder an einem Fahrzeug), Fahrzeugzubehör, Fluchtwegmarkierung, Geländer, als Schild, als Etikett, Uhrzeiger, Uhrzifferblatt, Uhrgehäuse, Uhrarmband oder Schmuckgegenstand ausgebildet ist.

13. Verfahren zur Herstellung eines Gegenstandes (1) gemäss einem der vorangehenden Ansprüche, enthaltend die folgenden Schritte:
a) Herstellung oder Bereitstellung eines lumineszierenden, insbesondere phosphoreszierenden Substrates (2) mit mindestens einer äusseren Oberfläche (3),
b) Aufbringung einer transparenten Deckschicht (4) auf wenigstens einen Teil der äusseren Oberfläche (3) des Substrates (2),
**dadurch gekennzeichnet, dass**
die transparente Deckschicht (4) mindestens ein Metall und/oder mindestens eine Metallverbindung enthält oder daraus besteht und in einer derartigen Dicke aufgebracht wird, dass sie bei einem Einfallswinkel von 60° einen Reflektometerwert aufweist, der mindestens 5, bevorzugt mindestens 10, besonders bevorzugt mindestens 15 beträgt.

14. Verfahren gemäss Anspruch 13,
**dadurch gekennzeichnet, dass**
in Schritt b) die transparente Deckschicht (4) mittels physikalischer Gasphasenabscheidung und/oder chemischer Gasphasenabscheidung und/oder mittels eines elektrochemischen Verfahrens und/oder durch mittels eines Tauchverfahrens aufgetragen wird.
